# EUROPÄISCHE PATENTSCHRIFT

(11) **EP 1 816 739 B1**
(45) Veröffentlichungstag und Bekanntmachung des Hinweises auf die Patenterteilung: **09.04.2008**
(21) Anmeldenummer: 06002315.7
(22) Anmeldetag: 04.02.2006
(51) Int. Cl.: H02P 31/00

(54) **Verfahren und Vorrichtung zur Regelung eines mehrphasigen, elektronisch kommutierten Motors**
Method and apparatus for control of a multi-phase electronically commutated motor
Procédé et dispositif de contrôle d'un moteur polyphasée et à commutation électronique

(43) Veröffentlichungstag der Anmeldung: 08.08.2007
(73) Patentinhaber: Diehl AKO Stiftung & Co. KG, 88239 Wangen (DE)
(72) Erfinder: Weinmann, Martin, 88339 Bad Waldsee (DE); Müller, Alexander, 88339 Bad Waldsee-Reute (DE); Zeh, Stefan, 88239 Wangen (DE)
(74) Vertreter: Kummer, Ralf

(56) Entgegenhaltungen:
- US-A- 6 121 736
- US-B1- 6 208 112

## Beschreibung

Die Erfindung bezieht sich auf ein Verfahren zur Regelung eines mehrphasigen, elektronisch kommutierten Motors. Die Erfindung bezieht sich weiterhin auf eine Vorrichtung zur Durchführung des genannten Verfahrens.

Bei einem elektronisch kommutierten (Elektro-)Motor ist zur Kommutierung, d.h. zur Ansteuerung der Motorphasen, ein Wechselrichter vorgesehen, der üblicherweise in Form einer Brückenschaltung realisiert ist. Eine solche Brückenschaltung umfasst eine der Anzahl der Motorphasen entsprechende Anzahl von Phasenhalbbrücken, wobei jede Phasenhalbbrücke über einen Spannungszwischenkreis mit dem Pluspol und dem Minuspol einer Gleichspannungsquelle verbunden ist und an einem Mittelabgriff eine Phasenanschlussklemme zum Anschluss einer zugeordneten Motorphase umfasst. Innerhalb einer jeden Phasenhalbbrücke ist zwischen der Phasenanschlussklemme und dem Pluspol ein hochpotentialseitiger Leistungsschalter, und zwischen der Phasenanschlussklemme und dem Minuspol ein niederpotentialseitiger Leistungsschalter angeordnet, über welchen der jeweilige Ast der Phasenhalbbrücke gesperrt oder freigegeben werden kann. Jedem Leistungsschalter ist eine Freilaufdiode parallel geschaltet, die in Richtung des Potentialgefälles zwischen Pluspol und Minuspol sperrend angeordnet ist.

Durch die Kommutierung werden in den Motorphasen oszillierende elektrische Ströme angeregt. Unter Wirkung dieser Motorphasenströme wird im Motor ein magnetisches Drehfeld erzeugt, welches einen Rotor des Motors zu einer Rotationsbewegung antreibt. Eine Motorregelung erfolgt üblicherweise anhand der Motorphasenströme und/oder so genannter Back-EMF-Spannungen, die durch die Rotordrehung in jede Motorphase induziert werden.

Aus der US 6,121,736 A ist ein Regelverfahren für einen elektrischen Motor der oben genannten Art bekannt, bei welchem zur Erfassung des Flussrichtungswechsels eines Motorphasenstroms (nachfolgend als Nulldurchgang des Motorphasenstroms bezeichnet) eine der betrachteten Motorphase zugeordnete Klemmenspannung während einer Totzeit der Leistungsschalter in der zugeordneten Phasenhalbbrücke detektiert wird. Der Nulldurchgang des Motorphasenstroms wird hierbei an einem Wechsel der Klemmenspannung zwischen einem dem Minuspol zugeordneten Massepotential und einem dem Pluspol zugeordneten Betriebspotential erkannt. Die Totzeit ist eine im Zuge eines Kommutierungsschaltprozesses vorgesehene Umschaltzeit, während der beide Leistungsschalter einer Phasenhalbbrücke kurzfristig sperrend angesteuert sind, um beim quasi-simultanen Schalten der Leistungsschalter einen Kurzschluss zwischen dem Pluspol und dem Minuspol zu vermeiden.

Ein Nachteil des bekannten Verfahrens liegt darin, dass zur Erfassung der Motorstromrichtung nur die vergleichsweise kurze Totzeit zur Verfügung steht. Eine Messung der Klemmenspannung ist mit schaltungstechnisch akzeptablem Aufwand nur dann möglich, wenn die Totzeit hinreichend groß dimensioniert ist. Diesem Erfordernis läuft die fortschreitende Entwicklung moderner Motoransteuerungen zuwider. Mit der kommerziellen Verfügbarkeit zunehmend präziserer Leistungsschalter werden auch zunehmend kürzere Totzeiten angestrebt, um einen störenden Einfluss totzeitbedingter Oberwellen der Motorphasenströme zu eliminieren.

Bei einem weiteren, aus der US 6,208,112 B1 bekannten Regelungsverfahren für einen Motor der oben genannten Art ist als Regelgröße die Phasenverschiebung zwischen einem Motorphasenstrom und der zugehörigen Back-EMF-Spannung vorgesehen. Diese Phasenverschiebung wird anhand der Abweichung zwischen dem Nulldurchgang des Motorphasenstroms und dem Nulldurchgang der Back-EMF-Spannung bestimmt. Die Messung der Back-EMF-Spannung erfolgt hierbei in einer Motorphase, die während der Messung vom Versorgungsnetz getrennt wird.

Der Erfindung liegt die Aufgabe zugrunde, ein Regelungsverfahren für einen mehrphasigen, elektronisch kommutierten Motor anzugeben, im Zuge dessen eine besonders präzise und messtechnisch einfache Erfassung einer regelungsrelevanten Größe, insbesondere eines Motorphasenstroms und/oder einer Back-EMF-Spannung und/oder einer hieraus abgeleiteten Größe stattfindet. Der Erfindung liegt weiterhin die Aufgabe zugrunde, eine zur Durchführung des genannten Verfahrens besonders geeignete Vorrichtung anzugeben.

Bezüglich des Verfahrens wird die Aufgabe erfindungsgemäß gelöst durch die Merkmale des Anspruchs 1. Danach ist vorgesehen, dass eine einer Motorphase zugeordnete, regelungsrelevante Größe durch Erfassung des Bestromungszustandes einer Freilaufdiode bestimmt wird, die innerhalb einer der Motorphase zugeordneten Phasenhalbbrücke einer Brückenschaltung angeordnet ist. Der Bestromungszustand wird hierbei während einer nachfolgend als "Einzeit" bezeichneten Zeitspanne erfasst, die dadurch definiert ist, dass ein der Freilaufdiode innerhalb der Phasenhalbbrücke parallel geschalteter Leistungsschalter "ein"-geschaltet ist, d.h. einen leitendenden Zustand aufweist, während ein der Freilaufdiode seriell geschalteter Leistungsschalter einen sperrenden Zustand aufweist.

Im Folgenden wird zwischen einer "betrachteten Motorphase" und den jeweils "weiteren Motorphasen" unterschieden. Durch diese Sprachregelung soll ausgedrückt werden, dass durch Erfassung des Bestromungszustands einer gegebenen Freilaufdiode stets eine regelungsrelevante Größe ermittelt wird, die derjenigen Motorphase zugeordnet ist, in deren zugeordneten Phasenhalbbrücke die Freilaufdiode angeordnet ist. Diese Motorphase wird nachfolgend, zur Unterscheidung von den "weiteren Motorphasen", als "betrachtete Motorphase" bezeichnet. Diese Sprachregelung ist jedoch nicht im Sinne einer Festlegung auf eine bestimmte, physikalische Motorphase zu verstehen. Vielmehr wird in bevorzugter Ausführung der Bestromungszustand jeweils einer Freilaufdiode einer jeden Phasenhalbbrücke erfasst, so dass, je nach Bezugnahme, eine jede Motorphase die "betrachtete Motorphase" sein kann.

Der Bestromungszustand der Freilaufdiode wird in einer zweckmäßigen Verfahrensvariante durch einen direkten Stromsensor, insbesondere einen der Freilaufdiode über seine Basis-Emitter-Strecke seriell geschalteten Bipolartransistor erfasst. In einer gleichermaßen bevorzugten alternativen Verfahrensvariante wird der Bestromungszustand der Freilaufdiode, z.B. mittels einer Komparatorschaltung, indirekt anhand einer über der Freilaufdiode abfallenden Referenzspannung bestimmt. Die indirekte Erfassung des Bestromungszustandes eignet sich insbesondere für vergleichsweise hohe Antriebsleistungen, zumal die indirekte Erfassung des Bestromungszustandes im Wesentlichen verlustlos erfolgt.

Diese Referenzspannung entspricht erkanntermaßen der (in Durchlassrichtung abfallenden) Flussspannung der Freilaufdiode, wenn diese bestromt ist. Ist die Freilaufdiode dagegen stromlos, so entspricht die Referenzspannung während der Einzeit der (in Sperrrichtung der Freilaufdiode abfallenden) Sättigungsspannung des parallel geschalteten Leistungsschalters. Die Referenzspannung ändert somit bei einer Änderung des Bestromungszustandes der Freilaufdiode das Vorzeichen, wodurch der Bestromungszustand der Freilaufdiode und eine Änderung desselben mit schaltungstechnisch besonders einfachen und damit insbesondere kostengünstigen Mitteln erkennbar ist.

Bevorzugt wird der Bestromungszustand der niederpotentialseitigen, d.h. der zwischen einer Phasenanschlussklemme und dem Minuspol angeordneten Freilaufdiode einer Phasenhalbbrücke bestimmt. Dies ist insbesondere unter dem Aspekt zweckmäßig, dass der Minuspol üblicherweise als Systemmasse herangezogen wird, auf die auch die Steuerungslogik einer Motoransteuerung gewöhnlicherweise bezogen ist. Grundsätzlich kann aber zusätzlich oder alternativ hierzu auch der Bestromungszustand der hochpotentialseitigen Freilaufdiode erfasst werden.

Als regelungsrelevante Größe wird in einer bevorzugten Ausführung des Verfahrens die Flussrichtung des in der betrachteten Motorphase fließenden Motorphasenstroms bestimmt. Eine niederpotentialseitig angeordnete Freilaufdiode ist während der Einzeit erkanntermaßen dann bestromt; wenn die Flussrichtung des zugeordneten Motorphasenstroms positiv ist, d.h. wenn der Motorstrom auf den Motor zufließt. Bei negativer Flussrichtung des Motorphasenstroms ist die Freilaufdiode dagegen unbestromt. Der Bestromungszustand einer hochpotentialseitigen Freilaufdiode verhält sich hierzu genau entgegengesetzt.

Vorzugsweise wird der Bestromungszustand der Freilaufdiode fortlaufend, d.h. während einer jeden Einzeit kontinuierlich oder zeitdiskret mit einer vorgegebenen Abtastrate überwacht, um Nulldurchgänge, d.h. Flussrichtungswechsel des Motorphasenstroms zu erkennen. Als für einen Nulldurchgang charakteristische Größen werden hierbei insbesondere der Zeitpunkt, zu dem der Nulldurchgang stattfindet, sowie optional ein dem Nulldurchgang zugeordnetes Vorzeichen erfasst. Ein Nulldurchgang wird hierbei positiv notiert, wenn der Motorphasenstrom von negativer Flussrichtung zu positiver Flussrichtung wechselt. Ein Flussrichtungswechsel von positiv zu negativ wird entsprechend als negativer Nulldurchgang bezeichnet. Aus den ermittelten Nulldurchgängen des Motorphasenstroms werden optional abgeleitete Größen wie die Frequenz des Motorphasenstroms und/oder die Phasenlage des Motorphasenstroms zu einem beliebigen Zeitpunkt bestimmt.

Zusätzlich oder alternativ zu der Flussrichtung des Motorphasenstroms wird in einer vorteilhaften Ausführung des Verfahrens als weitere regelungsrelevante Größe das Vorzeichen einer in die betrachtete Motorphase induzierten Back-EMF-Spannung anhand des Bestromungszustandes der Freilaufdiode bestimmt. Hierzu wird während einer Einzeit einer betrachteten Motorphase, insbesondere nach Abkommuteirung des betreffenden Motorphasenstroms, ein so genannter Nullvektorzustand hergestellt, im Zuge dessen alle Motorphasen auf einen gemeinsamen Pol des Spannungszwischenkreises geklemmt werden, so dass an die weiteren Motorphasen ein Klemmenpotential angelegt wird, das dem Klemmenpotential der betrachteten Motorphase im Wesentlichen entspricht. Wird der Bestromungszustand der niederpotentialseitigen Freilaufdiode bestimmt, so wird der Nullvektorzustand insbesondere realisiert, indem alle Motorphasen auf den Minuspol geklemmt werden.

Während des auf den Minuspol bezogenen Nullvektorzustands ist im Grenzfall eines geringen Motorphasenstroms das der betrachteten Motorphase zugeordnete Klemmenpotential gegenüber dem Massenpotential dann positiv, wenn die zugehörige Back-EMF-Spannung ein positives Vorzeichen aufweist. Entsprechend ist die niederpotentialseitige Freilaufdiode in diesem Fall stromlos. Umgekehrt ist die niederpotentialseitige Freilaufdiode dann bestromt, wenn die Back-EMF-Spannung ein negatives Vorzeichen aufweist.

Das Vorzeichen der Back-EMF-Spannung kann äquivalenterweise auch anhand des Bestromungszustandes einer hochpotentialseitigen Freilaufdiode ermittelt werden. Hierbei werden zur Herstellung des Nullvektorzustandes alle Motorphasen auf den Pluspol geklemmt. Die hochpotentialseitige Freilaufdiode ist bei positivem Vorzeichen der Back-EMF-Spannung bestromt und bei negativem Vorzeichen der Back-EMF-Spannung stromlos.

Bevorzugt werden als regelungsrelevante Größen sowohl die Flussrichtung des Motorphasenstroms als auch das Vorzeichen der Back-EMF-Spannung in der betrachteten Motorphase bestimmt. Die Bestimmung des Vorzeichens der Back-EMF-Spannung wird hierbei vorteilhafterweise immer dann vorgenommen, wenn zuvor ein Nulldurchgang des Motorphasenstroms erkannt wurde. Durch diese mit dem Nulldurchgang des Motorphasenstroms quasi-simultane Bestimmung des Vorzeichens der Back-EMF-Spannung wird gleichzeitig Information über eine qualitative Phasenverschiebung zwischen dem Motorphasenstrom und der Back-EMF-Spannung gewonnen, d.h. es kann festgestellt werden, ob die Back-EMF-Spannung dem Motorstrom nach- oder vorauseilt. Die Information über diese qualitative Phasenverschiebung wird in einer insbesondere bei einem Synchronmotor vorteilhaften Ausführung des Verfahrens als Regelgröße zur Phasenangleichung des Motorphasenstroms an die Back-EMF-Spannung herangezogen.

Um vor Herstellung des Nullvektorzustandes den in der Motorphase fließenden Motorstrom zu eliminieren, wird dem Nullvektorzustand zweckmäßigerweise ein Abkommutierungszustand vorausgeschaltet. Während des Abkommutierungszustandes wird die der betrachteten Motorphase zugeordnete Phasenhalbbrücke hochohmig geschaltet. Mit anderen Worten werden beide Leistungsschalter dieser Phasenhalbbrücke vorübergehend sperrend angesteuert. An die weiteren Motorphasen wird gleichzeitig ein Klemmenpotential angelegt, das dem Motorphasenstrom in der betrachteten Motorphase entgegenwirkt. Fließt der Motorphasenstrom in der betrachteten Motorphase also in positive Flussrichtung, so wird an die weiteren Motorphasen im Wesentlichen das Betriebspotential angelegt. Entsprechend werden die weiteren Motorphasen auf Masse gelegt, wenn zu Beginn des Abkommutierungszustandes der Motorphasenstrom in der betrachteten Motorphase in negative Flussrichtung floss.

Bezüglich der zur Durchführung des vorstehend beschriebenen Verfahrens vorgesehenen Vorrichtung wird die Aufgabe erfindungsgemäß gelöst durch die Merkmale des Anspruchs 10. Danach umfasst die Vorrichtung eine Brückenschaltung zur Ansteuerung eines mehrphasigen elektronisch kommutierten Motors. Die Brückenschaltung umfasst zu jeder Motorphase eine zugeordnete Phasenhalbbrücke, in welcher bezüglich einer Phasenanschlussklemme ein hochpotentialseitig angeordneter Leistungsschalter und ein niederpotentialseitig angeordneter Leistungsschalter angeordnet sind. Jedem Leistungsschalter ist hierbei eine Freilaufdiode parallel geschaltet. Die Vorrichtung umfasst weiterhin eine Steuereinheit, die zur Ansteuerung der Leistungsschalter der Brückenschaltung ausgebildet ist.

Erfindungsgemäß ist hierbei einer Freilaufdiode mindestens einer Phasenhalbbrücke eine Sensorschaltung zugeordnet, die dazu ausgebildet ist, während einer Einzeit gemäß obiger Definition den Bestromungszustand der Freilaufdiode zu ermitteln. Der Steuereinheit ist von der Sensorschaltung ein den Bestromungszustand kennzeichnender Ausgabewert zugeführt, anhand dessen die Steuereinheit nach dem vorstehend beschriebenen Verfahren eine regelungsrelevante Größe, insbesondere die Flussrichtung des Motorphasenstroms, das Vorzeichen der Back-EMF-Spannung oder eine hieraus abgeleitete Größe bestimmt.

Zweckmäßigerweise ist die Sensorschaltung einer niederpotentialseitig angeordneten Freilaufdiode zugeordnet. Bevorzugt ist der niederpotentialseitigen Freilaufdiode einer jeden Phasenhalbbrücke eine Sensorschaltung zugeordnet.

Für eine direkte Messung des Bestromungszustandes der Freilaufdiode umfasst die Sensorschaltung in einer bevorzugten Ausführung der Erfindung einen Bipolartransistor, der über seine Basis-Emitter-Strecke der Freilaufdiode seriell geschaltet ist. In einer alternativen Ausführung der Erfindung umfasst die Sensorschaltung zur indirekten Messung des Bestromungszustandes einen Komparator, dem zur Erfassung der über der Freilaufdiode abfallenden Referenzspannung ein anodenseitiges Diodenpotential und ein kathodenseitiges Diodenpotential der Freilaufdiode zugeführt ist.

In einer schaltungstechnisch besonders vorteilhaften Ausführung der Erfindung ist die Sensorschaltung zusammen mit der zugeordneten Freilaufdiode und dem der letzteren parallel geschalteten Leistungsschalter in einem gemeinsamen, insbesondere monolithisch ausgeführten Bauteil integriert, das als 4-Pol realisiert ist, d.h. zusätzlich zu den drei Eingängen des Leistungsschalters einen der Sensorschaltung zugeordneten Sensorausgang umfasst, an welchem das Ausgabesignal abgreifbar ist. Dieser Sensorausgang ist insbesondere als Open-Kollektor-Ausgang ausgeführt. Ein Open-Kollektor-Ausgang stellt anstelle eines aktiven Spannungssignals einen passiven Widerstandswert zur Kennzeichnung eines Signalzustandes zur Verfügung.

Die mit der Erfindung verknüpften Vorteile bestehen insbesondere darin, das mittels eines gemeinsamen Messprinzips, nämlich der Erfassung des Bestromungszustandes einer Freilaufdiode während des für die oben definierte Einzeit charakteristischen Schaltzustands, auf schaltungstechnisch besonders einfache und somit kostengünstige Weise regelungsrelevante Größen wie die Flussrichtung eines Motorphasenstroms und/oder das Vorzeichen einer Back-EMF-Spannung ermittelt werden können. Derartige Einzeiten treten bei einer gewöhnlichen Motoransteuerung von Haus aus und mit messtechnisch hinreichend großer Dauer auf, so dass insbesondere die Flussrichtung des Motorphasenstroms unproblematisch im Normalbetrieb des Motors bestimmbar ist. In Hinblick auf eine Erfassung der Back-EMF-Spannung ist das vorstehend beschriebene Messprinzip insbesondere insofern vorteilhaft, als die Messung der Back-EMF-Spannung während eines Nullvektorzustands erfolgt. Ein derartiger Nullvektorzustand wird typischerweise bei jedem Taktzyklus der Leistungsschalter einmal durchlaufen.

Zur konstruktiven Vereinfachung der Steuervorrichtung trägt insbesondere bei, dass die Flussrichtung des Motorphasenstroms und das Vorzeichen der Back-EMF-Spannung mit ein und derselben Sensorschaltung detektiert werden. Diese erlaubt trotz einfachem schaltungstechnischem Aufbau eine hochpräzise Messung, so dass insbesondere auch die vergleichsweise schwache, durch den Remanenzmagnetismus des Rotoreisens verursachte Back-EMF-Spannung eines Asynchronmotors sicher gemessen wird. Das Verfahren und die zugehörige Vorrichtung ist ebenso vorteilhaft auch bei einem Synchronmotor, insbesondere zur Phasenangleichung der Motorphasenströme an die Back-EMF-Spannung einsetzbar.

Nachfolgend werden Ausführungsbeispiele der Erfindung anhand einer Zeichnung näher erläutert. Darin zeigen:
- Fig. 1: in einem schematisch vereinfachten Blockschaltbild eine Vorrichtung zur Ansteuerung eines dreiphasigen, elektronisch kommutierten Motors, mit einer wechselrichterseitigen Brückenschaltung und einer diese ansteuernden Steuereinheit,
- Fig. 2: in einem elektronischen Schaltbild einen Leistungsschalter und eine parallel geschaltete Freilaufdiode der Brückenschaltung gemäß Fig. 1 mit einer als Komparatorschaltung ausgeführten Sensorschaltung zur Erfassung des Bestromungszustandes der Freilaufdiode,
- Fig. 3: in Darstellung gemäß Fig. 2 eine alternative Ausführung der Sensorschaltung,
- Fig. 4 bis 6: in Darstellung gemäß Fig. 2 weitere Ausführungen der Sensorschaltung,
- Fig. 7: in einem schematischen Diagramm für jede der drei Motorphasen den zeitlichen Verlauf des Motorphasenstroms, des Klemmenpotentials sowie der Phasenspannung bei einer sogenannten "Flat Bottom-Modulation",
- Fig. 8: in einem Diagramm mit gegenüber Fig. 7 verfeinerter Zeitskala Zeitausschnitte Va und Vb des Diagramms gemäß Fig. 7,
- Fig. 9: in Darstellung gemäß Fig. 7 den zeitlichen Verlauf der Motorphasenströme, Klemmenpotentiale und Phasenspannungen bei einer sogenannten "zentrischen Modulation" sowie zusätzlich den zeitlichen Verlauf der in eine jede Motorphase induzierten Back-EMF-Spannung,
- Fig. 10: in Darstellung gemäß Fig. 8 Zeitausschnitte VIIa und VIIb des Diagramms gemäß Fig. 9 in verfeinerter Zeitauflösung.

Einander entsprechende Teile und Größen sind in allen Figuren stets mit den gleichen Bezugszeichen versehen.

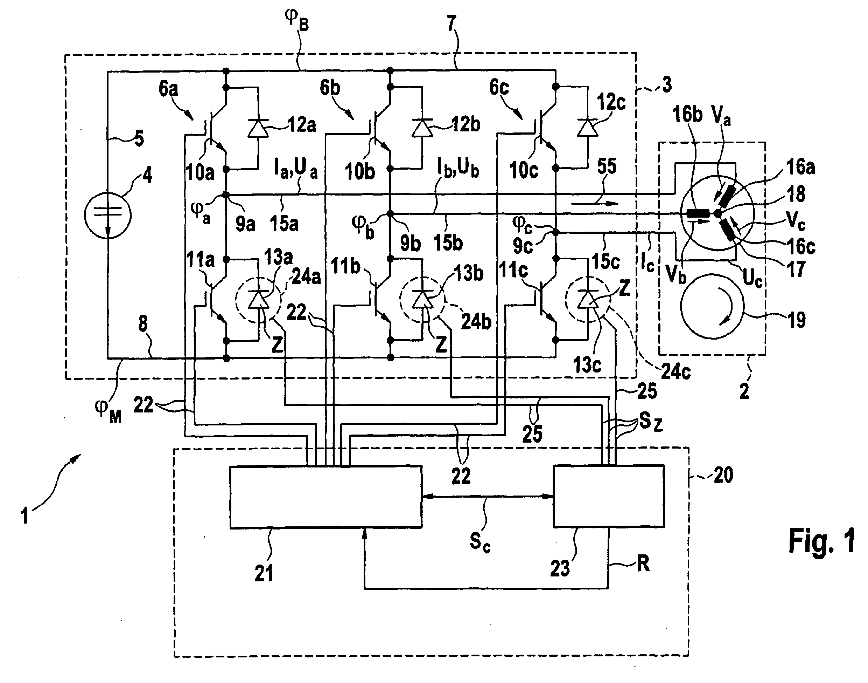

Fig. 1 zeigt in einem schematisch vereinfachten Blockschaltbild eine Vorrichtung 1 zur Regelung eines dreiphasigen, elektronisch kommutierten Motors 2. Bei dem Motor 2 handelt es sich exemplarisch um einen bürstenlosen Synchronmotor mit Permanentmagnet. Das nachfolgend beschriebene Verfahren und die zugehörige Vorrichtung 1 sind aber auch zur Regelung anderer Motortypen einsetzbar, insbesondere bei einem Asynchronmotor oder einem Reluktanz-Synchronmotor.

Die Vorrichtung 1 umfasst eine wechselrichterseitige Brückenschaltung 3, die von einer Gleichspannungsquelle 4 über einen Spannungszwischenkreis 5 spannungsversorgt wird. Die Brückenschaltung 3 umfasst drei Phasenhalbbrücken 6a,6b,6c, die in Parallelschaltung jeweils zwischen einen Pluspol 7 und einen Minuspol 8 des Spannungszwischenkreises 5 geschaltet sind. Jede Phasenhalbbrücke 6a,6b,6c weist an einem Mittelabgriff eine Phasenanschlussklemme 9a,9b, 9c auf. Der Phasenanschlussklemme 9a, 9b, 9c und dem Pluspol 7 ist innerhalb der jeweiligen Phasenhalbbrücke 6a,6b,6c ein hochpotentialseitiger Leistungsschalter 10a,10b, 10c zwischengeschaltet. Ebenso ist der jeweiligen Phasenanschlussklemme 9a,9b,9c und dem Minuspol 8 innerhalb der jeweiligen Phasenhalbbrücke 6a,6b,6c ein niederpotentialseitiger Leistungsschalter 11a,11b,11c zwischengeschaltet. Die Leistungsschalter 10a,10b,10c und 11a,11b,11c sind als Halbleiterschaltelemente, insbesondere IGBTs oder MOFETs ausgebildet. Jedem hochpotentialseitigem Leistungsschalter 10a,10b,10c ist eine hochpotentialseitige Freilaufdiode 12a,12b,12c parallel geschaltet. Ebenso ist jedem niederpotentialseitigen Leistungsschalter 11a,11b,11c eine zugehörige niederpotentialseitige Freilaufdiode 13a,13b,13c parallel geschaltet. Die Freilaufdioden 12a,12b,12c und 13a,13b,13c sind jeweils mit ihrer Durchlassrichtung auf den Pluspol 7 ausgerichtet und somit bezüglich des Potentialgefälles zwischen Pluspol 7 und Minuspol 8 in Sperrrichtung geschaltet.

Mit der Phasenanschlussklemme 9a,9b,9c einer jeden Phasenhalbbrücke 6a,6b,6c ist eine zugehörige Motorphase 15a,15b,15c des Motors 2 kontaktiert, der hier exemplarisch in Sternschaltung ausgeführt ist. Jede Motorphase 15a,15b,15c umfasst eine Erregerwicklung 16a,16b,16c, die in einem Stator 17 des Motors 2 angeordnet ist. Die Motorphasen 15a,15b,15c sind innerhalb des Stators 17 in einem Sternpunkt 18 zusammengeschlossen. Der Motor 2 umfasst weiterhin einen innnerhalb des Stators 17 rotierbar gelagerten Rotor 19, der insbesondere einen (nicht näher dargestellten) Permanentmagneten umfasst.

Die Vorrichtung 1 umfasst weiterhin eine Steuereinheit 20, die insbesondere als logische elektronische Schaltung ausgebildet ist. Die Steuereinheit 20 umfasst ein Schaltmodul 21 zur Aufsteuerung bzw. Zusteuerung der Leistungsschalter 10a, 10b,10c und 11a,11b,11c. Das Schaltmodul 21 ist hierzu über jeweils eine entsprechende Steuerleitung 22 mit dem Gate-Eingang eines jeden Leistungsschalters 1 0a,10b,10c und 11a,11b, 11c verbunden.

Zur Ermittlung einer (nachfolgend näher beschriebenen) Regelgröße R umfasst die Steuereinheit 20 weiterhin ein Auswertemodul 23. Das Auswertemodul 23 ist hierbei dazu ausgebildet, die Regelgröße R anhand des (stromlosen oder strombehafteten) Bestromungszustands Z einer jeden niederpotentialseitigen Freilaufdiode 13a,13b,13c zu bestimmen. Zur Erfassung des Bestromungszustands Z ist jeder der niederpotentialseitigen Freilaufdioden 13a,13b,13c eine Sensorschaltung 24a, 24b,24c zugeordnet, die ein den Bestromungszustand Z spezifizierendes Ausgabesignal S_{Z} über eine jeweilige Erfassungsleitung 25 dem Auswertemodul 23 zuführt. Das Auswertemodul 23 und Schaltmodul 21 sind zum Austausch von Steuersignalen S_{C} verbunden.

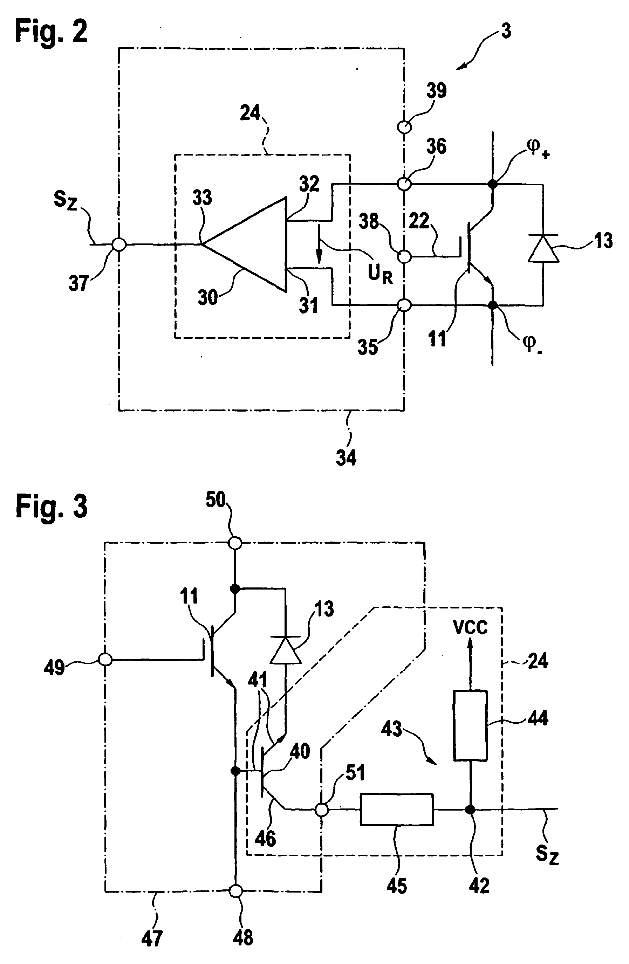

Ein niederpotentialseitiger Leistungsschalter 11, der exemplarisch für einen beliebigen Leistungsschalter 11a,11b,11c gemäß Fig. 1 steht, ist in den Fig. 2 und 3 zusammen mit der parallelgeschalteten Freilaufdiode 13 (entsprechend einer der Freilaufdioden 13a,13b,13c aus Fig. 1) und der dieser zugeordneten Sensorschaltung 24 (entsprechend einer der Sensorschaltungen 24a,24b,24c aus Fig. 1) vergrößert dargestellt. Die Sensorschaltung 24 ist in einer ersten Ausführung gemäß Fig. 2 als Komparatorschaltung ausgebildet. Die Sensorschaltung 24 umfasst hierbei einen Komparator 30, der über seine Eingänge 31 und 32 der jeweiligen Freilaufdiode 13 parallelgeschaltet ist, so dass der Eingang 31 mit einem anodenseitiges Diodenpotential ϕ₋ und der Eingang 32 mit einem kathodenseitiges Diodenpotential ϕ₊ belegt ist. Der Komparator 30 vergleicht die anliegenden Diodenpotentiale ϕ₋ und ϕ₊ und gibt an einem Ausgang 33 das Ausgabesignal Sz in Form eines logischen Signals aus, dessen Wert von dem Größenverhältnis der Diodenpotentiale ϕ₋ und ϕ₊, und somit von dem Vorzeichen einer über der Freilaufdiode 13 abfallenden Referenzspannung U_{R} = (ϕ₊ - ϕ₋) abhängt. Der Bestromungszustand Z wird hierbei indirekt über das Vorzeichen der Referenzspannung U_{R} bestimmt. Ist die Freilaufdiode 13 bestromt, so entspricht die Referenzspannung U_{R} der in Durchlassrichtung abfallenden und somit negativen Flussspannung der Freilaufdiode 13. Ist die Freilaufdiode 13 unbestromt, so ist die über ihr abfallende Referenzspannung U_{R} positiv.

Die Sensorschaltung 24 ist optional zusammen mit dem Schaltmodul 21 in einem gemeinsamen Treiberbaustein 34 integriert. In dieser Ausführung sind die Diodenpotentiale ϕ₋ und ϕ₊ an einen "COM"-Eingang 35 bzw. einen "Vs"-Eingang 36 des Treiberbausteins 34 angelegt, die bausteinintern mit den Eingängen 31 bzw. 32 des Komparators 30 kontaktiert sind. Das Ausgabesignal S_{Z} ist an einem mit dem Ausgang 33 des Komparators 30 verschalteten "Sign"-Ausgang 37 des Treiberbausteins 34 abgreifbar. Ein "LO"-Eingang 38 des Treiberbausteins 34 ist über die zugehörige Steuerleitung 22 mit dem Gate-Eingang des niederpotentialseitigen Leistungsschalters 11 verbunden. Ein "HO"-Eingang 39 des Treiberbausteins 34 ist entsprechend mit dem Gate-Eingang des (in Fig. 2 nicht dargestellten) zugehörigen hochpotentialseitigen Leistungsschalters 10a,10b,10c verbunden. Die Eingänge 38 u. 39 sind (in nicht näher dargestellter Weise) bausteinintern mit dem Schaltmodul 21 verbunden.

In einer alternativen Ausführung der Sensorschaltung 24 gemäß Fig. 3 wird der Bestromungszustand Z der Freilaufdiode 13 direkt gemessen. Hierzu ist der Freilaufdiode 13 ein Bipolartransistor 40 über dessen Basis-Emitter-Strecke 41 in Serie geschaltet. Das Ausgabesignal S_{Z} ist hierbei an einem Mittelabgriff 42 einer Spannungsteilerschaltung 43 abgreifbar, die über einen Widerstand 44 mit einem Versorgungspotential VCC und über einen Widerstand 45 mit einem Kollektoreingang 46 des Bipolartransistors 40 verbunden ist. Die Basis-Emitter-Strecke 41 des Bipolartransistors 40 hat hierbei selbst die schaltungstechnischen Eigenschaften einer gleichsinnig mit der Freilaufdiode 13 ausgerichteten Diode. Der Bipolartransistor 40 kann hierdurch bei entsprechender Auslegung die Freilaufdiode 13 auch vollständig ersetzen.

Optional sind der Leistungsschalter 11, die Freilaufdiode 13 und der Bipolartranistor 40 in einem gemeinsamen elektronischen Bauteil 47 kombiniert. Das Bauteil 47 ist als 4-Pol konzipiert. Es umfasst drei dem Leistungsschalter 11 zuzuordnende Anschlüsse 48, 49 und 50, von denen der Anschluss 48 zur Verbindung mit dem Minuspol 8, der Anschluss 49 als Steuereingang zur Verbindung mit dem Schaltmodul 21 und der Anschluss 50 zur Verbindung mit der jeweiligen Motorphasenklemme 9a,9b,9c vorgesehen ist. Das Bauteil 47 umfasst des Weiteren einen Sensorausgang 51, der mit dem Kollektoreingang 46 des Bipolartransistors 40 verbunden ist. Der Sensorausgang 51 hat die schaltungstechnischen Eigenschaften eines Open-Kollektor-Ausgangs und stellt einen in hochsensibler Weise von dem Bestromungszustand der Basis-Emitter-Strecke 41, und damit von dem Bestromungszustand Z der Freilaufdiode 13 abhängigen Widerstandswert zur Verfügung. Das Bauteil 47 ist bevorzugt monolithisch ausgeführt. Die Darstellung des Bipolartransistors 40 repräsentiert in diesem Fall kein separates Teil, sondern eine schaltungstechnische Charakteristik des Bauteils 47.

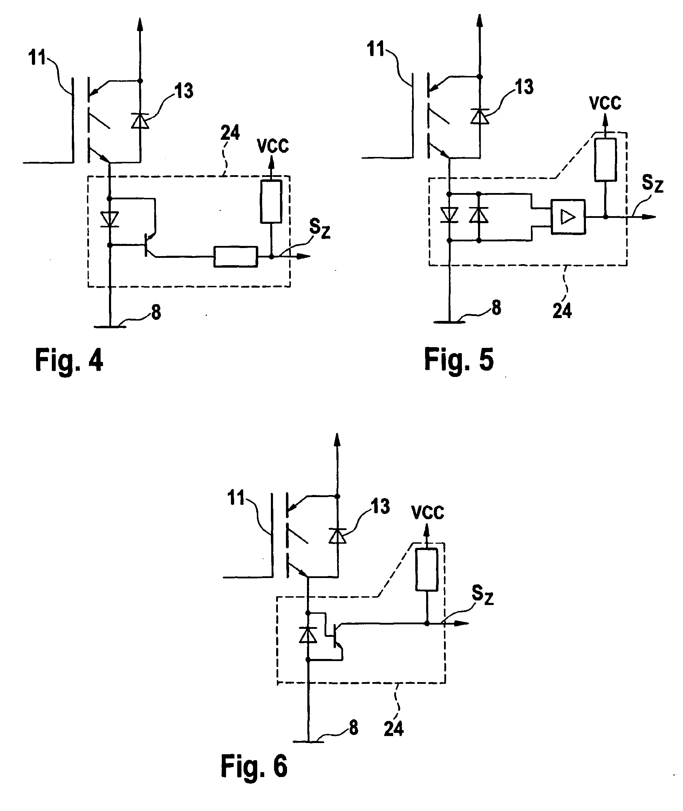

Weitere Ausführungsformen der Sensorschaltung 24 sind in den Fig. 4 bis 6 dargestellt. Im Gegensatz zu den vorstehend beschriebenen Ausführungsformen gemäß Fig. 2 und 3 ist die Sensorschaltung 24 hier jeweils dem aus dem niederpotentialseitigen Leistungsschalter 11 und der zugeordneten Freilaufdiode 13 gebildeten Halbleiterbaustein und dem Minuspol 8 zwischengeschaltet.

Im Betrieb des Motors 2 wird durch Kommutierung der Motorphasen 15a,15b, 15c, d.h. durch periodische Auf- bzw. Zusteuerung der Leistungsschalter 10a,10b 10c und 11a,11b,11c in jeder Motorphase 15a,15b,15c ein periodisch fluktuierender Motorphasenstrom Iₐ,I_{b},I_{c} erzeugt, wobei - wie in Fig. 1 angedeutet - der Motorphasenstrom Iₐ der Motorphase 15a, der Motorphasenstrom I_{b} der Motorphase 15b und der Motorphasenstrom I_{c} der Motorphase 15c zugeordnet ist. Die Motorphasenströme Iₐ,I_{b},I_{c} erzeugen im Stator 17 des Motors 2 ein rotierendes magnetisches Erregerfeld, das den Rotor 19 antreibt. Ein innerhalb einer Motorphase 15a,15b,15c auf den Motor 2 zufließender Motorphasenstrom Iₐ,I_{b},I_{c} wird nachfolgend mit einem positiven Vorzeichen notiert. Ein positiver Motorphasenstrom Iₐ,I_{b},I_{c} fließt somit entlang einer in Fig. 1 angedeuteten Flussrichtung 55. Entsprechend wird ein von dem Motor 2 wegfließender Motorphasenstrom Iₐ,I_{b},I_{c} mit negativem Vorzeichen notiert. Ein entsprechender Motorphasenstrom Iₐ,I_{b},I_{c} fließt somit in eine der Flussrichtung 55 entgegengesetzte Flussrichtung.

Zur Steuerung der Phasenströme Iₐ,I_{b},I_{c} wird durch Auf- bzw. Zusteuerung der Leistungsschalter 10a,10b,10c und 11a,11b,11c ein Klemmenpotential ϕₐ,ϕ_{b},ϕ_{c} an der jeweils zugehörigen Phasenanschlussklemme 9a,9b,9c eingestellt.

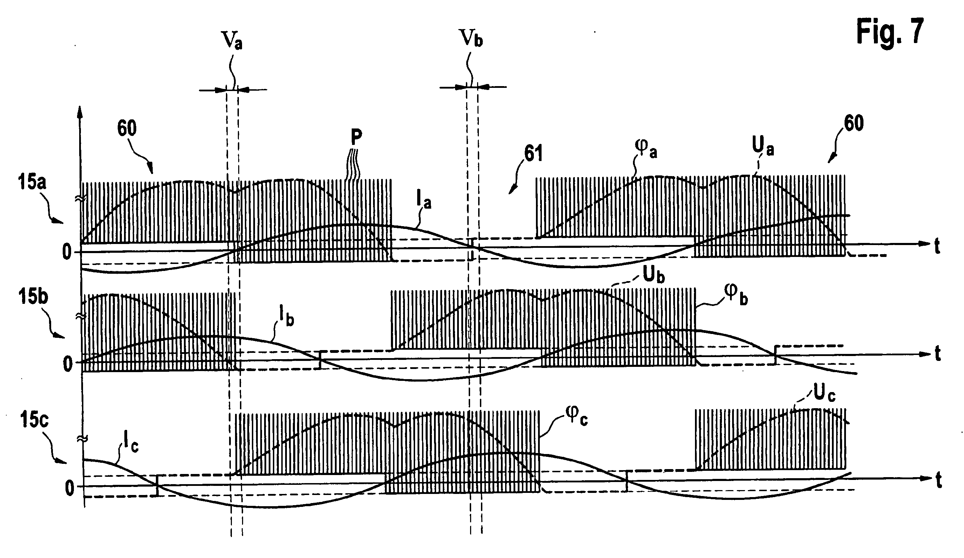

Der hochpotentialseitige Leistungsschalter 10a,10b,10c und der zugehörige niederpotentialseitige Leistungsschalter 11a,11b,11c einer jeden Phasenhalbbrücke 6a,6b,6c werden hierbei - sofern nicht explizit anders ausgeführt - stets antiparallel angesteuert, so dass innerhalb einer jeden Phasenhalbbrücke 6a,6b,6c jeweils ein Leistungsschalter 10a,10b,10c bzw. 11a,11b,11c einen leitenden Zustand aufweist, während der andere Leistungsschalter 10a,10b,10c bzw. 11a,11b, 11c einen sperrenden Zustand aufweist. Ist der hochpotentialseitige Leistungsschalter 10a,10b,10c einer Phasenhalbbrücke 6a,6b,6c leitend, so entspricht das zugeordnete Klemmenpotential ϕₐ,ϕ_{b},ϕ_{c} im Wesentlichen einem dem Pluspol 7 zugeordneten Betriebspotential ϕ_{B}. Ist dagegen der niederpotentialseitige Leistungsschalter 11a,11b,11c leitend, so entspricht das zugeordnete Klemmenpotential φₐ,φ_{b},φ_{c} näherungsweise einem an dem Minuspol 8 abgreifbaren Massenpotential ϕ_{M}. Ein Wechsel des Schaltzustandes innerhalb einer Phasenhalbbrücke 6a,6b,6c erfolgt in der Regel quasi-simultan für beide Leistungsschalter 10a,10b, 10c und 11a,11b,11c, genauer innerhalb der eingangs eingeführten Totzeit, die aufgrund ihrer geringen Dauer für die nachfolgenden Ausführungen aber vernachlässigbar ist. Die Ansteuerung der Motorphasen Iₐ,I_{b},I_{c} wird durch das Schaltmodul 21 unter Anwendung einer Pulsweitenmodulation (PWM) vorgenommen. Dabei wird der hochpotentialseitige Leistungsschalter 10a,10b,10c der anzusteuernden Motorphase 15a,15b,15c durch eine Serie von Steuerpulsen P (Fig. 7) angesteuert, die mit einer vorgegebenen Taktfrequenz aufeinander folgen. Die als Pulsweite bezeichnete Dauer eines jeden Steuerpulses P wird im Zuge des Regelungsverfahrens zwischen 0% und 100% der Taktdauer eines PWM-Taktes moduliert. Für die auf den Steuerpuls P folgende Zeitspanne eines PMW-Taktes ist der hochpotentialseitige Leistungsschalter 10a,10b,10c abgeschaltet, und die zugehörige Motorphase 15a,15b,15c durch Aufsteuerung des entsprechenden niederpotentialseitigen Leistungsschalters 11a,11b,11c auf den Minuspol 8 geklemmt. Bei der in Fig. 1 dargestellten Schaltungskonfiguration entspricht eine durch diesen Schaltzustand gekennzeichnete Zeitspanne einer Einzeit im Sinne der obigen Definition.

Als Phasenspannung Uₐ,U_{b},U_{c} wird nachfolgend der über den PWM-Takt gebildete zeitliche Mittelwert des entsprechenden Klemmenpotentials ϕₐ,ϕ_{b},ϕ_{c} bezeichnet. Eine jede Phasenspannung Uₐ,U_{b},U_{c} ist auf das Massenpotential ϕ_{M} bezogen und variiert zwischen 0V und dem Betriebspotential ϕ_{B}. Die Phasenspannung Uₐ,U_{b},U_{c} ist hierbei direkt proportional zu der Pulsweite, mit welcher die entsprechende Motorphase 15a,15b,15c angesteuert wird.

In der Praxis werden verschiedene Varianten der pulsweitenmodulierten Motoransteuerung eingesetzt, auf die das erfindungsgemäße Verfahren gleichermaßen anwendbar ist. Exemplarisch ist in Fig. 7 eine sogenannte "Flat Bottom"-Modulation dargestellt. Fig. 7 zeigt in einem Diagramm gegen die Zeit t für jede Motorphase 15a,15b,15c separiert den jeweiligen Motorphasenstrom Iₐ, I_{b},I_{c}, das zugeordnete Klemmenpotential ϕₐ,ϕ_{b},ϕ_{c} sowie die jeweilige Phasenspannung Uₐ,U_{b},U_{c}.

Dem Diagramm gemäß Fig. 7 ist zunächst zu entnehmen, dass die Phasenströme Iₐ,I_{b},I_{c} periodisch gemäß einer zumindest im Wesentlichen sinusförmigen Zeitabhängigkeit variieren. Die Periode dieser sinusförmigen Zeitabhängigkeit entspricht einer Volldrehung des Erregerfelds, sowie - bei einem Synchronmotor mit N Polpaaren- einer N-tel Drehung des Rotors 19. Ein Zeitintervall innerhalb des Diagramms ist somit direkt proportional zu einer Änderung des Phasenwinkels des Erregerfelds bzw. der Rotorbewegung.

Bei der "Flat Bottom"-Modulation gemäß Fig. 7 wird jede Motorphase 15a,15b, 15c während eines einem Phasenwinkelbereich von 240° entsprechenden ersten Teilzyklus 60 einer jeden Periode pulsweitenmoduliert angesteuert. Dieser Teilzyklus 60 in der Darstellung gemäß Fig. 7 an den jeweils einem Steuerpuls P entsprechenden Spitzen der Klemmenpotentiale ϕₐ,ϕ_{b},ϕ_{c} zu erkennen, die aus Gründen der begrenzten Zeitauflösung in Fig. 7 unter Vernachlässigung ihrer jeweiligen zeitlichen Ausdehnung lediglich als senkrechte Striche angedeutet sind. Wie an dem korrespondierenden Verlauf der jeweiligen Phasenspannung Uₐ,U_{b},U_{c} zu erkennen ist, nimmt die hierzu proportionale Pulsweite der Steuerpulse P im Verlauf der ersten Hälfte des Teilzyklus 60 zu, durchläuft zwei Maxima und nimmt in der zweiten Hälfe des Teilzyklus 60 wieder ab. An den Teilzyklus 60 schließt ein zweiter Teilzyklus 61 an, der einem Phasenwinkelbereich von 120° entspricht und die Periode somit vervollständigt, d.h. sich mit dem Teilzyklus 60 zu einem Vollzyklus, entsprechend einem Phasenwinkelbereich von 360°, ergänzt. Während des Teilzyklus 61 ist die jeweilige Motorphase 15a,15b,15c permanent auf das Massenpotential ϕ_{M} geklemmt. Die Phasenspannung Uₐ,U_{b},U_{c} entspricht während dieses Teilzyklus 61 dem zugehörigen Klemmenpotential ϕₐ,ϕ_{b},ϕ_{c}.

Nachfolgend wird in exemplarisch auf die Motorphase 15a beschränkter Betrachtung das Verhalten des Klemmenpotentials ϕₐ bei einem Nulldurchgang des zugehörigen Motorphasenstroms Iₐ näher erläutert. Als positiver Nulldurchgang wird hierbei ein Nulldurchgang bezeichnet, bei welchem die Flussrichtung von negativ zu positiv wechselt. Ein solcher positiver Nulldurchgang ereignet sich gemäß Fig. 7 innerhalb des markierten Zeitausschnitts Va. Als negativer Nulldurchgang wird ein Nulldurchgang des Motorphasenstroms Iₐ bezeichnet, bei welchem die Flussrichtung von positiv auf negativ wechselt. Ein solcher negativer Nulldurchgang ereignet sich innerhalb des markierten Zeitausschnitts Vb.

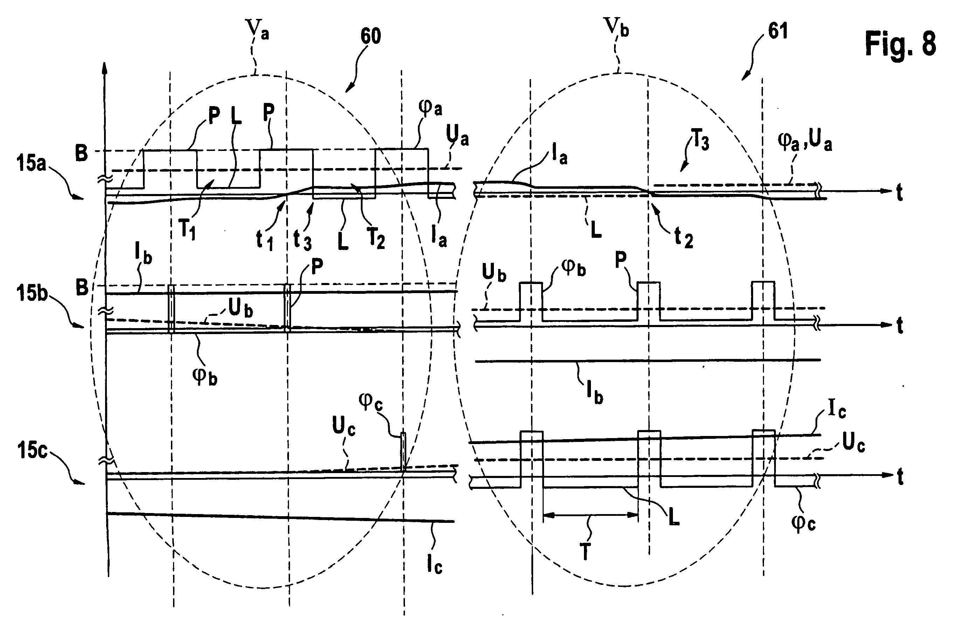

Diese Zeitausschnitte Va und Vb sind in Fig. 8 in verfeinerter Zeitauflösung nochmals dargestellt. Fig. 8 ist insbesondere entnehmbar, dass ein Sockelwert L, den das Klemmenpotential ϕₐ jeweils während einer jeden Einzeit T einnimmt, von der Flussrichtung bzw. dem Vorzeichen des zugehörigen Motorphasenstroms Iₐ bestimmt ist. Für den gemäß Fig. 8 zu einem Zeitpunkt t₁ stattfindenden positiven Nulldurchgang ist der Sockelwert L des Klemmenpotentials ϕₐ vor dem Nulldurchgang geringfügig positiv, danach geringfügig negativ. Bei dem gemäß Fig. 8 zu einem Zeitpunkt t₂ stattfindenden negativen Nulldurchgang verhält sich das Klemmenpotential ϕₐ entgegengesetzt, weist also vor dem Nulldurchgang einen geringfügig negativen Wert und nach dem Nulldurchgang einen geringfügig positiven Wert auf.

Der Sockelwert L des Klemmenpotentials ϕₐ ist hierbei durch den Bestromungszustand Z der Freilaufdiode 13a bestimmt. Infolge der Kontinuität, d.h. der induktiv bedingten "Trägheit" des Motorphasenstroms Iₐ fließt der Motorphasenstrom Iₐ bei negativer Flussrichtung während der Einzeit über den Leistungsschalter 11a ab. Der Motorphasenstrom Iₐ ist dabei in Sperrrichtung der Freilaufdiode 13a gerichtet, die somit unbestromt ist. Das Klemmenpotential ϕₐ hat infolgedessen gegenüber dem Massenpotential ϕ_{M} einen der Sättigungsspannung des Leistungsschalters 11a entsprechenden positiven Wert. Bei positiver Flussrichtung ist der Stromfluss dagegen in Durchlassrichtung der Freilaufdiode 13a gerichtet, die somit bestromt ist. Der Sockelwert L des Klemmenpotentials ϕₐ ist infolgedessen um einen der Flussspannung der Freilaufdiode 13a entsprechenden Betrag gegenüber dem Massenpotential ϕ_{M} erniedrigt und somit insbesondere negativ.

Der Bestromungszustand Z der Freilaufdiode 13a bzw. die durch ihn bedingte Abhängigkeit des Sockelwertes L des Klemmenpotentials ϕₐ wird verfahrensgemäß ausgenützt, um die Flussrichtung, und insbesondere Nulldurchgänge des Motorphasenstroms Iₐ zu bestimmen.

Wie wiederum aus Fig. 8 zu erkennen ist, findet ein positiver Nulldurchgang des Motorphasenstroms Iₐ stets während eines Steuerpulses P statt. Der Nulldurchgang wird hierbei anhand der Änderung des Sockelwertes L zwischen einer dem Nulldurchgang unmittelbar vorausgehenden Einzeit T₁ und einer hierauf folgenden Einzeit T₂ festgestellt. Die Erkennung des Nulldurchgangs erfolgt damit insbesondere zu einem den Beginn der Einzeit T₂ kennzeichnenden Zeitpunkt t₃ und somit mit geringer Zeitverschiebung gegenüber dem exakten Zeitpunkt t₁ des Nulldurchgang.

Ein negativer Nulldurchgang erfolgt dagegen während des Teilzyklus 61, der aufgrund des damit verbundenen Schaltzustands über seine gesamte Länge eine Einzeit T₃ im Sinne der obigen Definition darstellt. Der Nulldurchgang wird daher mit der durch die Abtastrate des Bestromungszustandes Z vorgegebenen Genauigkeit unmittelbar zum Zeitpunkt t₂ erkannt.

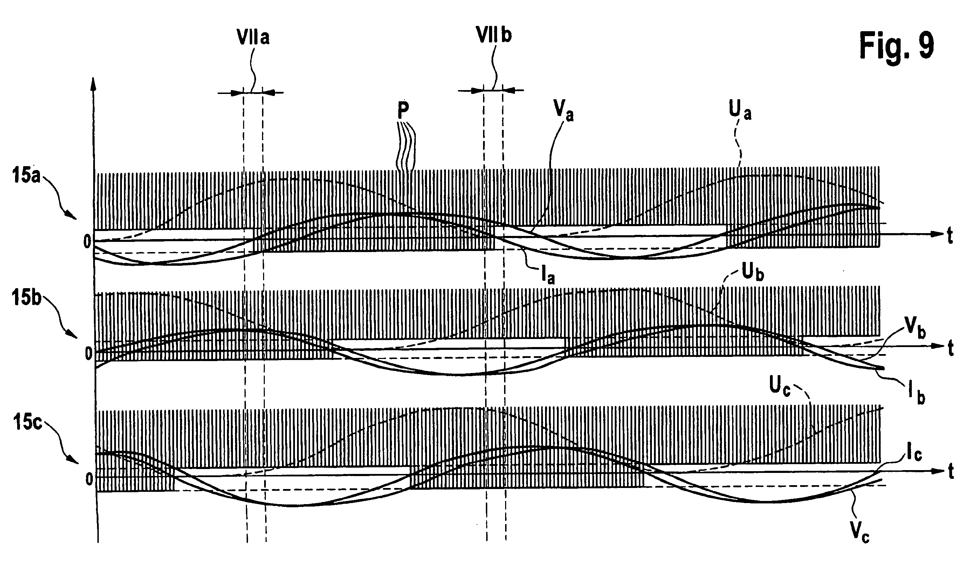

Ein weiteres Beispiel einer pulsweitenmodulierten Motoransteuerung, auf die das erfindungsgemäße Verfahren anwendbar ist, ist in Fig. 9 (in zu Fig. 7 analoger Darstellung) abgebildet. Hierbei handelt es sich um eine so genannte "zentrische Modulation", bei welcher jede Motorphase 15a,15b,15c über den Vollzyklus des Phasenwinkels getaktet angesteuert wird. Wie anhand der jeweilige Phasenspannung Uₐ,U_{b},U_{c} erkennbar ist, variiert die Pulsweite der Steuerpulse P in jeder Motorphase 15a,15b,15c beispielhaft gemäß einer sinusförmigen zeitlichen Abhängigkeit mit der Periode der Motorphasenströme Iₐ,I_{b},I_{c}. Zusätzlich zu den Motorphasenströmen Iₐ, I_{b},I_{c}, den Phasenspannungen Uₐ,U_{b},U_{c} und den Klemmenpotentialen ϕₐ,ϕ_{b},ϕ_{c} ist in Fig. 9 der zeitliche Verlauf einer Back-EMF-Spannung Vₐ,V_{b},V_{c} eingetragen, die durch die gegenelektromotorische Kraft (Back-EMF) des Rotors 19 in jede Motorphase 15a,15b,15c induziert wird. Die in die Motorphasen 15a,15b,15c induzierten Back-EMF-Spannungen Vₐ,V_{b},V_{c} sind auf den ggf. virtuellen Sternpunkt 18 als gemeinsames Bezugspotential bezogen. In der Darstellung gemäß Fig. 9 eilt die Back-EMF-Spannung Vₐ,V_{b},V_{c} gegenüber dem jeweils zugehörigen Motorphasenstrom Iₐ,I_{b},I_{c} geringfügig nach.

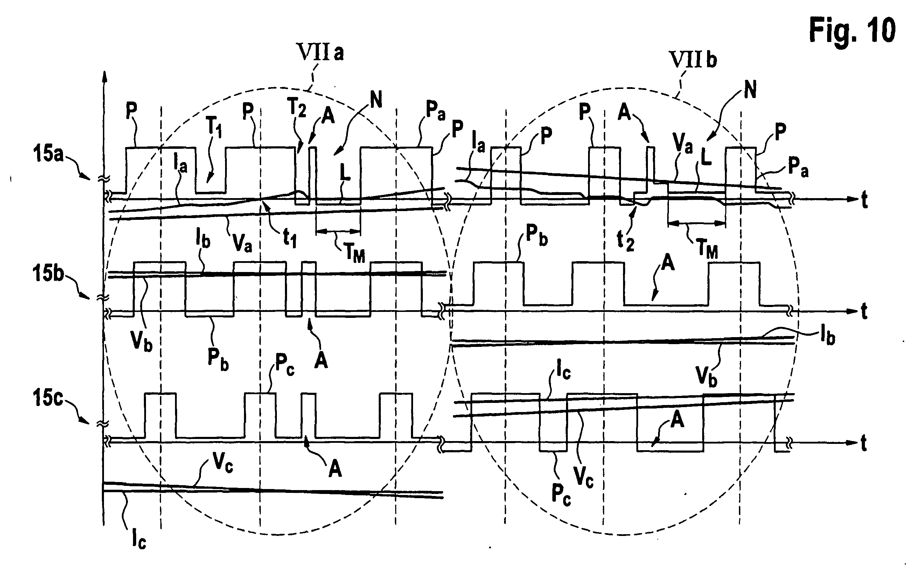

Eine Verfahrensvariante, gemäß der (wiederum exemplarisch anhand der Motorphase 15a betrachtet) durch Erfassung des Bestromungszustandes Z der Freilaufdiode 13a das Vorzeichen der Back-EMF-Spannung Vₐ,V_{b},V_{c}, und insbesondere ihre qualitative (d.h. positive oder negative) Phasenverschiebung gegenüber dem zugehörigen Motorphasenstrom Iₐ,I_{b},I_{c} bestimmt wird, ist nachfolgend anhand der Fig. 9 und 10 näher erläutert. In der letzteren Figur sind analog zu Fig. 8 Zeitausschnitte VIIa und VIIb des Diagramms gemäß Fig. 9, die einem positiven bzw. negativen Nulldurchgang des exemplarisch betrachteten Motorphasenstroms Iₐ entsprechen, in verfeinerter Zeitauflösung dargestellt.

Die Back-EMF-Spannung Vₐ,V_{b},V_{c} einer Motorphase 15a,15b,15c kann gemessen werden, sobald der durch die Induktivität der Erregerwicklungen 16a,16b,16c getriebene Stromfluß abgeklungen ist, und der Reststrom in einer Motorphase 15a,15b,15c im Fall kurzgeschlossener Phasenanschlussklemmen 9a,9b,9c durch die Back-EMF-Spannung Vₐ,V_{b},V_{c} der betrachteten Motorphase 15a,15b, 15c getrieben wird.

Die Bestimmung des Vorzeichens der Back-EMF-Spannung Vₐ erfolgt, indem während einer Messzeit T_{M} ein so genannter Nullvektorzustand N an die Motorphasen 15a,15b,15c angelegt wird. Hierzu wird durch Aufsteuerung der Leistungsschalter 11a,11b,11c nicht nur die betrachtete Motorphase 15a, sondern auch die weiteren Motorphasen 15b und 15c auf das Massenpotential ϕ_{M} geklemmt. Während des Nullvektorzustands N ist die Freilaufdiode 13a dann bestromt, wenn die Back-EMF-Spannung Vₐ negativ ist, und infolgedessen das Klemmenpotential ϕₐ das Massenpotential ϕ_{M} unterschreitet. Ist die Back-EMF-Spannung Vₐ dagegen positiv, so ist die Freilaufdiode 13a stromlos.

Dementsprechend wird während der gemäß Fig. 10 innerhalb des Zeitausschnitts VIIa geschalteten Messzeit Tₘ aufgrund der negativen Back-EMF-Spannung Vₐ ein negativer Sockelwert L gemessen bzw. der strombehaftete Bestromungszustand Z der Freilaufdiode 13a als Indiz für das negative Vorzeichen der Back-EMF-Spannung Vₐ erfasst.

Im Gegensatz dazu wird während der innerhalb des Zeitausschnitts VIIb geschalteten Messzeit T_{M} ein positiver Sockelwert L des Klemmenpotentials ϕₐ bzw. der stromlose Bestromungszustand Z der Freilaufdiode 13a als Kennzeichen des positiven Vorzeichens der Back-EMF-Spannung Vₐ erfasst.

Die Erfassung der Back-EMF-Spannung Vₐ wird jeweils bei Erkennung eines Nulldurchgangs des zugehörigen Motorphasenstroms Iₐ, und damit zu einem Zeitpunkt, zu dem der Stromfluss in der betrachteten Motorphase 15a von Haus aus besonders gering ist, vorgenommen. Zur Eliminierung des Reststroms wird der Anlegung des Nullvektorzustandes N ein Abkommutierungszustand A in der Motorphase 15a vorgeschaltet. Im Zuge des Abkommutierungszustandes A wird die Phasenhalbbrücke 6a durch Abschattung beider Leistungsschalter 10a und 11a hochohmig geschaltet. Die Klemmenpotentiale ϕ_{b} und ϕ_{c} der weiteren Motorphasen 15b und 15c werden gleichzeitig auf einen Wert gesetzt, der dem Stromfluss in der betrachteten Motorphase 15a entgegenwirkt.

Unmittelbar nach Erkennung des innerhalb des Zeitausschnitts VIIa stattfindenden positiven Nulldurchgangs des Motorphasenstroms Iₐ werden entsprechend die weiteren Motorphasen 15b, 15c auf das Betriebspotential ϕ_{B} geklemmt. Die erfolgreiche Abkommutierung des Motorphasenstroms Iₐ ist in diesem Fall daran zu erkennen, dass die Freilaufdiode 13a stromlos wird und entsprechend das Klemmenpotential ϕₐ von einem negativen Wert auf einen annähernd dem Betriebspotential ϕ_{B} entsprechenden Wert anwächst.

Unmittelbar nach Erkennung des während des Zeitausschnitts VIIb stattfindenden negativen Nulldurchgangs des Motorphasenstroms Iₐ werden die weiteren Motorphasen 15b und 15c dagegen im Zuge des Abkommutierungszustandes A auf das Massepotential ϕ_{M} geklemmt. Der Abkommutierungsvorgang äußert sich in diesem Fall derart, dass unmittelbar mit der Sperrung der beiden Leistungsschalter 10a und 11a der Phasenhalbbrücke 6a das Klemmenpotential φₐ sprunghaft auf einen dem Betriebspotential ϕ_{B} im Wesentlichen entsprechenden Wert ansteigt und mit dem Versiegen des Motorphasenstroms Iₐ auf einen geringen Wert zurückfällt. In diesem Fall kann die Erfassung des Bestromungszustandes Z zur Bestimmung der Back-EMF-Spannung Vₐ bereits während des Abkommutierungszustandes A beginnen, sobald der Motorphasenstrom Iₐ abgefallen ist.

Das erfindungsgemäße Verfahren ist entsprechend auf weitere gängige Arten einer pulsweitenmodulierten Motoransteurung, insbesondere auf eine sogenannte Blockkommutierung anwendbar. Optional werden weiterhin, z.B. nach einem an sich aus der US 6,249,094 bekannten Verfahren, die Back-EMF-Spannungen Vₐ,V_{b},V_{c} auch quantitativ bestimmt.

Im Betrieb des Motors 2 erfasst die Auswerteeinheit 23 während jeder Einzeit T einer jeden Phasenhalbbrücke 6a,6b,6c den von der entsprechenden Sensofschaltung 24a,24b,24c bestimmten Bestromungszustand Z der entsprechenden Freilaufdiode 13a,13b,13c. Die Erfassung des Bestromungszustands Z erfolgt mindestens einmal pro Einzeit T. Die Auswerteeinheit 23 wird hierbei über das Steuersignal S_{C} von dem Schaltmodul 21 entsprechend "getriggert". Erkennt das Auswertemodul 23 nach der im Zusammenhang mit den Fig. 7 und 8 beschriebenen Vorgehensweise einen Nulldurchgang eines Phasenstroms Iₐ,I_{b},I_{c}, so ermittelt sie nach der im Zusammenhang mit den Fig. 9 und 10 beschriebenen Vorgehensweise das Vorzeichen der Back-EMF-Spannung Vₐ,V_{b},V_{c}. Hierzu veranlasst das Auswertemodul 23 das Schaltmodul 21 durch Abgabe von entsprechenden Steuersignalen S_{c} zur Erzeugung des Abkommutierungszustandes A bzw. zur Erzeugung des Nullvektorzustandes N.

Anhand der Flussrichtung bzw. des Vorzeichens der Motorphasenströme Iₐ,I_{b},I_{c} und/oder Back-EMF-Spannungen Vₐ,V_{b},V_{c} sowie gegebenenfalls anhand von hieraus abgeleiteten Nulldurchgängen dieser Größen ermittelt das Auswertemodul 23 die Regelgröße R und übermittelt diese an das Schaltmodul 21.

Bei der Regelgröße R handelt es sich insbesondere um die einen Nulldurchgang der Phasenströme Iₐ,I_{b},I_{c} und/oder der Back-EMF-Spannungen Vₐ,V_{b},V_{c} zugeordneten Zeitpunkte, die dem Schaltmodul 21 in Form eines Trigger-Signals zugeführt werden. Alternativ handelt es sich bei der Regelgröße R um eine hieraus abgeleitete Größe, insbesondere die Drehzahl, oder ein qualitatives oder quantitatives Maß für die Phasenverschiebung zwischen einem Motorphasenstrom Iₐ,I_{b},I_{c} und der zugeordneten Back-EMF-Spannung Vₐ,V_{b},V_{c}. Die Drehzahl wird hierbei durch Ermittlung des Zeitintervalls zwischen aufeinander folgenden Nulldurchgängen bestimmt. Als qualitatives Maß für die genannte Phasenverschiebung wird das Vorzeichen der Back-EMF-Spannung Vₐ,V_{b},V_{c} zum Zeitpunkt eines Nulldurchgangs des zugehörigen Motorphasenstroms Iₐ,I_{b},I_{c} übermittelt.

Das Schaltmodul 21 steuert die Brückenschaltung 3 insbesondere derart an, dass die als Regelgröße R zugeführte Ist-Drehzahl an eine vorgegebenen Soll-Drehzahl angegelichen wird. Optional wird die Ansteuerung zusätzlich oder alternativ derart vorgenommen, dass die als weitere Regelgröße R erhobene Ist-Phasenverschiebung zwischen den Motorströmen Iₐ,I_{b},I_{c} und den zugehörigen Back-EMF-Spannungen Vₐ,V_{b},V_{c} betragsmäßig minimiert wird.

Konkrete Ausführungsbeispiele derartiger Regelungsalgorithmen sind an sich bekannt und beispielsweise in den Dokumenten US 6,249,094 B1, US 6,208,112 B1 und US 6,121,736 A beschrieben.

Eine spezielle Anwendungsmöglichkeit des beschriebenen Verfahrens besteht in der sicheren Erkennung der Drehzahl eines Permanentmagnet-Synchronmotors oder eines Asynchronmotors im Auslauf oder einer sonstigen ansteuerungsfreien Freilaufphase. Während eines solchen Freilaufs werden einer oder mehrere der Leistungsschalter 11 a,11 b,11 c permanent aufgesteuert. Dabei werden unter Wirkung der Back-EMF Kreisströme durch die kurzgeschlossenen Motorphasen 15a, 15b,15c erzeugt, durch welche ein Bremsmoment auf den Rotor 19 ausgeübt wird. Auch bei einem Asynchronmotor existiert aufgrund des Remanenzmagnetismus im Rotoreisen eine, wenn auch im Vergleich zu einem Permanentmagnet-Synchronmotor wesentlich schwächere Back-EMF. Zumal der Bestromungszustand Z ein sehr empfindliches Maß für die an den Freilaufdioden 13a,13b,13c anliegenden Spannungsverhältnisse darstellt, kann auch die sehr schwache Back-EMF eines Asynchronmotors sicher gemessen werden. Falls erforderlich wird hierbei der Remanenzmagnetismus des Rotoreisens durch einen der Freilaufphase vorausgehenden Statorpuls aufgefrischt, um die Amplitude der Back-EMF-Spannungen Vₐ,V_{b},V_{c} zu verstärken. Auf diese Weise kann insbesondere im Auslauf die Drehzahl des Motors 2 bis nahezu zum Stillstand verfolgt werden. Diese Funktionalität ist nützlich, um den sicheren Stillstand des Motors 2 zu erkennen.

## Patentansprüche

1. Verfahren zur Regelung eines mittels einer wechselrichterseitigen Brückenschaltung (3) kommutierten, mehrere Motorphasen (15a,15b,15c) aufweisenden Motors (2),
**dadurch gekennzeichnet,**
**dass** zur Bestimmung einer regelungsrelevanten Größe einer betrachteten Motorphase (15a,15b,15c) der Bestromungszustand (Z) einer Freilaufdiode (13, 13a,13b,13c), die in einer der betrachteten Motorphase (15a,15b,15c) zugeordneten Phasenhalbbrücke (6a,6b,6c) der Brückenschaltung (3) angeordnet ist, während einer Einzeit (T,T₁,T₂,T₃) erfasst wird, in welcher ein der Freilaufdiode (13,13a,13b,13c) parallelgeschalteter Leistungsschalter (11,11a,11b,11c) der Phasenhalbbrücke (6a) einen leitenden Zustand, und ein der Freilaufdiode (13,13a,13b,13c) seriell geschalteter Leistungsschalter (10a, 10b,10c) einen sperrenden Zustand aufweist.

2. Verfahren nach Anspruch 1,
**dadurch gekennzeichnet,**
**dass** der Bestromungszustand (Z) der Freilaufdiode (13,13a,13b,13c) anhand einer über der Freilaufdiode (13,13a,13b,13c) abfallenden Referenzspannung (U_{R}) bestimmt wird.

3. Verfahren nach Anspruch 1 oder 2,
**dadurch gekennzeichnet,**
**dass** die Freilaufdiode (13,13a,13b,13c), deren Bestromungszustand (Z) bestimmt wird, innerhalb der der betrachteten Motorphase (15a,15b,15c) zugeordneten Phasenhalbbrücke (6a,6b,6c) bezüglich einer Phasenanschlussklemme (9a,9b,9c) niederpotentialseitig angeordnet ist.

4. Verfahren nach einem der Ansprüche 1 bis 3,
**dadurch gekennzeichnet,**
**dass** als regelungsrelevante Größe anhand des Bestromungszustandes (Z) die Flussrichtung eines in der betrachteten Motorphase (15a,15b,15c) fließenden Motorphasenstroms (Iₐ,I_{b},I_{c}) bestimmt wird.

5. Verfahren nach Anspruch 4,
**dadurch gekennzeichnet,**
**dass** zur Ermittlung von Nulldurchgängen des Motorphasenstroms (Iₐ,I_{b},I_{c}) der Bestromungszustand (Z) der Freilaufdiode (13,13a,13b,13c) fortlaufend überwacht wird, wobei ein Nulldurchgang an einer Änderung des Bestromungszustandes (Z) erkannt wird.

6. Verfahren nach einem der Ansprüche 1 bis 5,
**dadurch gekennzeichnet,**
**dass** als regelungsrelevante Größe anhand des Bestromungszustandes (Z) das Vorzeichen einer von dem Motor (2) in die betrachtete Motorphase (15a,15b,15c) induzierten Back-EMF-Spannung (Vₐ,V_{b},V_{c}) bestimmt wird, indem ein Nullvektorzustand (N) bezüglich eines an die betrachtete Motorphase (15a,15b,15c) angelegten Klemmenpotentials (ϕₐ,ϕ_{b},ϕ_{c}) und weiterer jeweils an eine der weiteren Motorphasen (15a,15b,15c) angelegten Klemmenpotentiale (ϕₐ,ϕ_{b},ϕ_{c}) hergestellt wird.

7. Verfahren nach Anspruch 6,
**dadurch gekennzeichnet,**
**dass** die Bestimmung des Vorzeichens der Back-EMF-Spannung (Vₐ,V_{b},V_{c}) bei Erkennung eines Nulldurchgangs des Motorphasenstroms (Iₐ,I_{b},I_{c}) in der betrachteten Motorphase (15a,15b,15c) vorgenommen wird.

8. Verfahren nach Anspruch 6 oder 7,
**dadurch gekennzeichnet,**
**dass** vor Herstellung des Nullvektorzustandes (N) zur Abkommutierung des Motorstroms (Iₐ,I_{b},I_{c}) in der betrachteten Motorphase (15a,15b,15c) ein Abkommutierungszustand (A) herbeigeführt wird, bei welchem die der betrachteten Motorphase (15a,15b,15c) zugeordnete Phasenhalbbrücke (6a,6b,6c) hochohmig geschaltet wird und an die weiteren Motorphasen (15a,15b,15c) ein dem Motorphasenstrom (Iₐ,I_{b},I_{c}) in der betrachteten Motorphase (15a, 15b,15c) entgegenwirkendes Klemmenpotential (ϕₐ,ϕ_{b},ϕ_{c}) angelegt wird.

9. Verfahren nach einem der Ansprüche 6 bis 8,
**dadurch gekennzeichnet,**
**dass** anhand eines Flussrichtungswechsels des Motorphasenstroms (Iₐ,I_{b},I_{c}) und des Vorzeichens der Back-EMF-Spannung (Vₐ,V_{b},V_{c}) zu diesem Zeitpunkt (t₁,t₂) eine Phasenverschiebung zwischen dem Motorphasenstrom (Iₐ,I_{b},I_{c}) und der Back-EMF-Spannung (Vₐ,V_{b},V_{c}) als Regelgröße (R) ermittelt wird.

10. Vorrichtung (1) zur Ansteuerung eines mehrphasigen, elektronisch kommutierten Motors (2), mit einer wechselrichterseitigen Brückenschaltung (3), innerhalb welcher jeder Motorphase (15a,15b,15c) eine Phasenhalbbrücke (6a,6b,6c) zugeordnet ist, die einen bezüglich einer Phasenanschlussklemme (9a,9b,9c) hochpotentialseitig angeordneten Leistungsschalter (10a,10b,10c) und einen bezüglich der Phasenanschlussklemme (9a,9b,9c) niederpotentialseitig angeordneten Leistungsschalter (11,11a,11b,11c), sowie jeweils eine einem jeden Leistungsschalter (10a,10b,10c,11,11a,11b,11c)parallelgeschaltete Freilaufdiode (12a,12b,12c,13,13a,13b,13c) umfasst, sowie mit einer Steuereinheit (20) zur Ansteuerung der Leistungsschalter (10a,10b,10c,11,11a,11b,11c) der Brückenschaltung (3),
**dadurch gekennzeichnet,**
**dass** einer Freilaufdiode (13,13a,13b,13c) mindestens einer Phasenhalbbrücke (6a,6b,6c) eine Sensorschaltung (24,24a,24b,24c) zugeordnet ist, die dazu ausgebildet ist, während einer Einzeit (T,T₁,T₂,T₃), in welcher ein der Freilaufdiode (13,13a,13b,13c) parallelgeschalteter Leistungsschalter (13, 13a,13b,13c) einen leitenden Zustand, und ein der Freilaufdiode (13,13a,13b,13c) seriell geschalteter Leistungsschalter (12a,12b,12c) einen sperrenden Zustand aufweist, einen Bestromungszustand (Z) der Freilaufdiode (13,13a,13b,13c) zur Erfassung einer regelungsrelevanten Größe der betrachteten Motorphase (15a) zu ermitteln.

11. Vorrichtung (1) nach Anspruch 10,
**dadurch gekennzeichnet,**
**dass** die oder jede Sensorschaltung (24,24a,24b,24c) einer bezüglich der zugehörigen Phasenanschlussklemme (9a,9b,9c) niederpotentialseitig angeordneten Freilaufdiode (13,13a,13b,13c) zugeordnet ist.

12. Vorrichtung (1) nach Anspruch 10 oder 11,
**dadurch gekennzeichnet,**
**dass** die Sensorschaltung (24,24a,24b,24c) einen Komparator (30) umfasst, dem ein anodenseitiges Diodenpotential (ϕ₋) und ein kathodenseitiges Diodenpotential (ϕ₊) der Freilaufdiode (13,13a,13b,13c) als Eingangspotential zugeführt ist.

13. Vorrichtung (1) nach Anspruch 10 oder 11,
**dadurch gekennzeichnet,**
**dass** die Sensorschaltung (24,24a,24b,24c) einen Bipolartransistor (40) umfasst, der über seine Basis-Emitter-Strecke (41) der Freilaufdiode (13,13a, 13b,13c) in Serie geschaltet ist.

14. Vorrichtung (1) nach einem der Ansprüche 10 bis 13,
**dadurch gekennzeichnet,**
**dass** die Sensorschaltung (24,24a,24b,24c) zusammen mit der zugeordneten Freilaufdiode (13,13a,13b,13c) und dem dem dieser parallelgeschalteten Leistungsschalter (11,11a,11b,11c) in einem gemeinsamen Bauteil (47) integriert sind.

15. Vorrichtung (1) nach Anspruch 14,
**dadurch gekennzeichnet,**
**dass** ein der Sensorschaltung (24,24a,24b,24c) zugeordneter und ein den Bestromungszustand (Z) der Freilaufdiode (13,13a,13b,13c) kennzeichnendes Ausgabesignal (S_{Z}) zur Verfügung stellender Sensorausgang (51) des Bauteils (47) als Open-Kollektor-Ausgang ausgeführt ist.

## Claims

1. Method for controlling a motor (2) that is commutated by means of an inverter-side bridge circuit (3) and exhibits a number of motor phases (15a, 15b, 15c), **characterized in that** in order to determine a control-relevant variable of a considered motor phase (15a, 15b, 15c), the current state (Z) of a freewheeling diode (13, 13a, 13b, 13c) that is arranged in a phase half bridge (6a, 6b, 6c), assigned to the considered motor phase (15a, 15b, 15c), of the bridge circuit (3), is detected during an on time (T, T₁, T₂, T₃) in which a circuit breaker (11, 11a, 11b, 11c), connected in parallel with the freewheeling diode (13, 13a, 13b, 13c), of the phase half bridge (6a) exhibits a conducting state, and a circuit breaker (10a, 10b, 10c) connected in series with the freewheeling diode (13, 13a, 13b, 13c) exhibits a blocking state.

2. Method according to Claim 1, **characterized in that** the current state (Z) of the freewheeling diode (13, 13a, 13b, 13c) is determined with the aid of a reference voltage (U_{R}) dropping across the freewheeling diode (13, 13a, 13b, 13c).

3. Method according to Claim 1 or 2, **characterized in that** the freewheeling diode (13, 13a, 13b, 13c) whose current state (Z) is being determined is arranged on the low-potential side with reference to a phase terminal (9a, 9b, 9c) within the phase half bridge (6a, 6b, 6c) assigned to the considered motor phase (15a, 15b, 15c).

4. Method according to one of Claims 1 to 3, **characterized in that** the flow direction of a motor phase current (Iₐ, I_{b}, I_{c}) flowing in the considered motor phase (15a, 15b, 15c) is determined as control-relevant variable with the aid of the current state (Z).

5. Method according to Claim 4, **characterized in that** the current state (Z) of the freewheeling diode (13, 13a, 13b, 13c) is monitored continuously in order to determine zero crossings of the motor phase current (Iₐ, I_{b}, I_{c}), a zero crossing being recognized from a change in the current state (Z).

6. Method according to one of Claims 1 to 5, **characterized in that** the sign of a back EMF voltage (Vₐ, V_{b}, V_{c}) induced by the motor (2) in the considered motor phase (15a, 15b, 15c) is determined as control-relevant variable with the aid of the current state (Z), this being done by producing a zero vector state (N) with reference to a terminal potential (ϕₐ, ϕ_{b}, ϕ_{c}) applied to the considered motor phase (15a, 15b, 15c), and with reference to further terminal potentials (ϕₐ, ϕ_{b}, ϕ_{c}) respectively applied to one of the further motor phases (15a, 15b, 15c).

7. Method according to Claim 6, **characterized in that** the determination of the sign of the back EMF voltage (Vₐ, V_{b}, V_{c}) is performed upon recognition of a zero crossing of the motor phase current (Iₐ, I_{b}, I_{c}) in the considered motor phase (15a, 15b, 15c).

8. Method according to Claim 6 or 7, **characterized in that** before the production of the zero vector state (N), for the purpose of the off-commutation of the motor current (Iₐ, I_{b}, I_{c}) in the considered motor phase (15a, 15b, 15c), an off-commutation state (A) is brought about in which the phase half bridge (6a, 6b, 6c) assigned to the considered motor phase (15a, 15b, 15c) is connected to high impedance, and a terminal potential (ϕₐ, ϕ_{b}, ϕ_{c}) counteracting the motor phase current (Iₐ, I_{b}, I_{c}) in the considered motor phase (15a, 15b, 15c) is applied to the further motor phases (15a, 15b, 15c).

9. Method according to one of Claims 6 to 8, **characterized in that** a phase shift between the motor phase current (Iₐ, I_{b}, Iₑ) and the back EMF voltage (Vₐ, V_{b}, V_{c}) is determined as controlled variable (R) with the aid of a change in the flow direction of the motor phase current (Iₐ, I_{b}, I_{c}) and of the sign of the back EMF voltage (Vₐ, V_{b}, V_{c}) at this instant (t₁, t₂).

10. Device (1) for driving a multiphase, electronically commutated motor (2), having an inverter-side bridge circuit (3) within which each motor phase (15a, 15b, 15c) is assigned a phase half bridge (6a, 6b, 6c) that comprises a circuit breaker (10a, 10b, 10c) arranged on the high-potential side with reference to a phase terminal (9a, 9b, 9c), and a circuit breaker (11, 11a, 11b, 11c) arranged on the low-potential side with reference to the phase terminal (9a, 9b, 9c), as well as respectively a freewheeling diode (12a, 12b, 12c, 13, 13a, 13b, 13c) connected in parallel with one circuit breaker (10a, 10b, 10c, 11, 11a, 11b, 11c) each, as well as having a control unit (20) for driving the circuit breakers (10a, 10b, 10c, 11, 11a, 11b, 11c) of the bridge circuit (3), **characterized in that** a freewheeling diode (13, 13a, 13b, 13c) of at least one phase half bridge (6a, 6b, 6c) is assigned a sensor circuit (24, 24a, 24b, 24c) that is designed so as to determine a current state (Z) of the freewheeling diode (13, 13a, 13b, 13c) for detecting a control-relevant variable of the considered motor phase (15a) during an on time (T, T₁, T₂, T₃) in which a circuit breaker (11, 11a, 11b, 11c) connected in parallel with the freewheeling diode (13, 13a, 13b, 13c) exhibits a conducting state, and a circuit breaker (12a, 12b, 12c) connected in series with the freewheeling diode (13, 13a, 13b, 13c) exhibits a blocking state.

11. Device (1) according to Claim 10, **characterized in that** the or each sensor circuit (24, 24a, 24b, 24c) is assigned to a freewheeling diode (13, 13a, 13b, 13c) arranged on the low-potential side with reference to the associated phase terminal (9a, 9b, 9c).

12. Device (1) according to Claim 10 or 11, **characterized in that** the sensor circuit (24, 24a, 24b, 24c) comprises a comparator (30) that is fed as input potential an anode-side diode potential (ϕ₋) and a cathode-side diode potential (ϕ₊) of the freewheeling diode (13, 13a, 13b, 13c).

13. Device (1) according to Claim 10 or 11, **characterized in that** the sensor circuit (24, 24a, 24b, 24c) comprises a bipolar transistor (40) that is connected in series via its base-emitter junction (41) to the freewheeling diode (13, 13a, 13b, 13c).

14. Device (1) according to one of Claims 10 to 13, **characterized in that** the sensor circuit (24, 24a, 24b, 24c), together with the assigned freewheeling diode (13, 13a, 13b, 13c) and the circuit breaker (11, 11a, 11b, 11c) connected in parallel therewith, is integrated in a common subassembly (47).

15. Device (1) according to Claim 14, **characterized in that** a sensor output (51), which is assigned to the sensor circuit (24, 24a, 24b, 24c) and makes available an output signal (S_{Z}) characterizing the current state (Z) of the freewheeling diode (13, 13a, 13b, 13c), of the subassembly (47) is designed as an open-collector output.

## Revendications

1. Procédé pour la régulation d'un moteur (2) à commutation, présentant plusieurs phases de moteur (15a,15b,15c), au moyen d'un circuit en pont (3) situé du côté de l'onduleur,
**caractérisé en ce que**,
pour la détermination d'une grandeur, pertinente pour la régulation, d'une phase de moteur considérée (15a,15b,15c), l'état d'alimentation (Z) d'une diode de roue libre (13,13a,13b,13c) qui est disposée dans un demi-pont de phase (6a,6b,6c) du circuit en pont (3) associé à la phase de moteur considérée (15a,15b,15c), est enregistré pendant un temps de marche (T,T₁,T₂,T₃), pendant lequel un sectionneur de puissance (11,11a,11b,11c) du demi-pont de phase (6a), monté en parallèle par rapport à la diode de roue libre (13,13a,13b,13c), présente un état conducteur, et pendant lequel un sectionneur de puissance (10a,10b,10c) monté en série avec la diode de roue libre (13,13a,13b,13c) présente un état bloquant.

2. Procédé selon la revendication 1,
**caractérisé en ce que**
l'état d'alimentation (Z) de la diode de roue libre (13,13a,13b,13c) est déterminé au moyen d'une chute de tension de référence (U_{R}) provoquée par la diode de roue libre (13,13a,13b,13c).

3. Procédé selon la revendication 1 ou 2,
**caractérisé en ce que**
la diode de roue libre (13,13a,13b,13c), dont l'état d'alimentation (Z) est déterminé, est disposée à l'intérieur du demi-pont de phase (6a,6b,6c) associé à la phase de moteur considérée (15a,15b,15c), du côté du faible potentiel en ce qui concerne une borne de raccordement de phase (9a,9b,9c).

4. Procédé selon l'une quelconque des revendications 1 à 3,
**caractérisé en ce que**,
comme grandeur pertinente pour la régulation, la direction du flux d'un courant de phase de moteur (Iₐ,I_{b},I_{c}) circulant dans la phase de moteur considérée (15a,15b,15c) est déterminée au moyen de l'état d'alimentation (Z).

5. Procédé selon la revendication 4,
**caractérisé en ce que**,
pour la recherche de passages par zéro du courant de phase de moteur (Iₐ,I_{b},I_{c}), l'état d'alimentation (Z) de la diode de roue libre (13,13a,13b,13c) est surveillé d'une façon continue, un passage par zéro étant reconnu à une modification de l'état d'alimentation (Z).

6. Procédé selon l'une quelconque des revendications 1 à 5,
**caractérisé en ce que**,
comme grandeur pertinente pour la régulation, le signe d'une tension de force contre-électromotrice (Vₐ,V_{b},V_{c}) induite par le moteur (2) dans la phase de moteur considérée (15a,15b,15c) est déterminé au moyen de l'état d'alimentation (Z), tandis qu'est produit un état de vecteur nul (N) relatif à un potentiel de borne (ϕₐ,ϕ_{b},ϕ_{c}) appliqué à la phase de moteur considérée (15a,15b,15c) et relatif à d'autres potentiels de borne (ϕₐ,ϕ_{b},ϕ_{c}) appliqués respectivement à chacune des autres phases de moteur (15a,15b,15c).

7. Procédé selon la revendication 6,
**caractérisé en ce que**
la détermination du signe de la tension de force contre-électromotrice (Vₐ,V_{b},V_{c}) est effectuée lors de la reconnaissance d'un passage par zéro du courant de phase de moteur (Iₐ,I_{b},I_{c}) dans la phase de moteur considérée (15a,15b,15c).

8. Procédé selon la revendication 6 ou 7,
**caractérisé en ce que**,
avant la production de l'état de vecteur nul (N) en vue de supprimer le courant de moteur (Iₐ,I_{b},I_{c}) dans la phase de moteur considérée (15a,15b,15c), un état de suppression de courant (A) est provoqué, dans lequel le demi-pont de phase (6a,6b,6c) associé à la phase de moteur considérée (15a, 15b, 15c) est connecté comme un circuit à haute impédance, et dans lequel un_potentiel de borne (ϕₐ,ϕ_{b},ϕ_{c}) agissant en sens inverse du courant de phase de moteur (Iₐ,I_{b},I_{c}) dans la phase de moteur considérée (15a,15b,15c) est appliqué aux autres phases de moteur (15a,15b,15c).

9. Procédé selon l'une quelconque des revendications 6 à 8,
**caractérisé en ce que**,
au moyen d'un changement de direction de flux du courant de phase de moteur (Iₐ,I_{b},I,) et du signe de la tension de force contre-électromotrice (Vₐ,V_{b},V_{c}), à cet instant (t₁,t₂), un déphasage entre le courant de phase de moteur (Iₐ,I_{b},I_{c}) et la tension de force contre-électromotrice (Vₐ,V_{b},V_{c}) est déterminé comme grandeur de réglage (R).

10. Dispositif (1) destiné à l'excitation d'un moteur polyphasé à commutation électronique (2), muni d'un circuit en pont (3) situé du côté de l'onduleur, dans lequel à chaque phase de moteur (15a,15b,15c) est associé un demi-pont de phase (6a,6b,6c) qui comprend un sectionneur de puissance (10a,10b,10c) disposé du côté du potentiel élevé en ce qui concerne une borne de raccordement de phase (9a,9b,9c), et un sectionneur de puissance (11,11a,11b,11c) disposé du côté du faible potentiel en ce qui concerne la borne de raccordement de phase (9a,9b,9c), ainsi que, chaque fois, une diode de roue libre (12a,12b,12c,13,13a,13b,13c) montée en parallèle par rapport à un sectionneur de puissance respectif (10a,10b,10c,11,11a,11b,11c), et muni d'une unité de commande (20) pour exciter le sectionneur de puissance (10a,10b,10c,11,11a,11b,11c) du circuit en pont (3),
**caractérisé en ce que**
à une diode de roue libre (13,13a,13b,13c) d'au moins un demi-pont de phase (6a,6b,6c), une commutation par capteur (24,24a,24b,24c) est associée, qui est configurée pour déterminer, pendant un temps de marche (T,T₁,T₂,T₃), pendant lequel un sectionneur de puissance (11,11a,11b,11c) monté en parallèle par rapport à la diode de roue libre (13,13a,13b,13c) présente un état conducteur, et pendant lequel un sectionneur de puissance (12a,12b,12c) monté en série avec la diode de roue libre (13,13a,13b,13c) présente un état bloquant, un état d'alimentation (Z) de la diode de roue libre (13,13a,13b,13c) en vue de l'enregistrement d'une grandeur, pertinente pour la régulation, de la phase de moteur (15a) considérée.

11. Dispositif (1) selon la revendication 10,
**caractérisé en ce que**
la ou chaque commutation par capteur (24,24a,24b,24c) est associée à une diode de roue libre (13,13a,13b,13c) disposée du côté du faible potentiel en ce qui concerne la borne de raccordement de phase y afférente (9a,9b,9c).

12. Dispositif (1) selon la revendication 10 ou 11,
**caractérisé en ce que**
la commutation par capteur (24,24a,24b,24c) comprend un comparateur (30) dans lequel sont introduits, en tant que potentiels d'entrée, un potentiel de diode (ϕ₋) situé du côté de l'anode, et un potentiel de diode (ϕ₊) situé du côté de la cathode, de la diode de roue libre (13, 13a, 13b, 13c) .

13. Dispositif (1) selon la revendication 10 ou 11,
**caractérisé en ce que**
la commutation par capteur (24,24a,24b,24c) comprend un transistor bipolaire (40) qui est monté en série, via son chemin base-émetteur (41), avec la diode de roue libre (13,13a,13b,13c).

14. Dispositif (1) selon l'une quelconque des revendications 10 à 13,
**caractérisé en ce que**
la commutation par capteur (24,24a,24b,24c) est intégrée dans un composant commun (47) conjointement avec la diode de roue libre associée (13,13a,13b,13c) et avec le sectionneur de puissance (11,11a,11b,11c) monté en parallèle par rapport à celle-ci.

15. Dispositif (1) selon la revendication 14,
**caractérisé en ce que**
une sortie de capteur (51) du composant (47), associée à la commutation par capteur (24,24a,24b,24c), et mettant à disposition un signal de sortie (S_{Z}) caractérisant l'état d'alimentation (Z) de la diode de roue libre (13,13a,13b,13c), est réalisée en tant que sortie à collecteur ouvert.
